# EUROPEAN PATENT SPECIFICATION

(11) **EP 1 290 546 B1**
(45) Date of publication and mention of the grant of the patent: **11.08.2004**
(21) Application number: 01931962.3
(22) Date of filing: 25.05.2001
(51) Int. Cl.: G06F 15/78, G06F 17/50

(54) **PROGRAMMABLE SINGLE-CHIP DEVICE AND RELATED DEVELOPMENT ENVIRONMENT**
PROGRAMMIERBARE EINZELCHIP-VORRICHTUNG UND ENTSPRECHENDE ENTWICKLUNGSUMGEBUNG
DISPOSITIF MONOPUCE PROGRAMMABLE ET ENVIRONNEMENT DE DEVELOPPEMENT ASSOCIE

(30) Priority: 25.05.2000 GB 0012773
(43) Date of publication of application: 12.03.2003
(73) Proprietor: Radioscape Limited, London NW1 4DS (GB)
(72) Inventor: FERRIS, Gavin, Robert, London N19 5LT (GB)
(74) Representative: Langley, Peter James
(86) International application number: PCT/GB2001/002363
(87) International publication number: WO 2001/090882

(56) References cited:
- WO-A-00/31652
- DE-A- 19 819 505
- GOKHALE M B ET AL: "NAPA C: compiling for a hybrid RISC/FPGA architecture" FPGAS FOR CUSTOM COMPUTING MACHINES, 1998. PROCEEDINGS. IEEE SYMPOSIUM ON NAPA VALLEY, CA, USA 15-17 APRIL 1998, LOS ALAMITOS, CA, USA,IEEE COMPUT. SOC, US, 15 April 1998 (1998-04-15), pages 126-135, XP010298178 ISBN: 0-8186-8900-5
- 'MIT PROGRAMMIERBARER LOGIK VERHEIRATET' ELEKTRONIK, FRANZIS VERLAG GMBH. MUNCHEN, DE vol. 47, no. 7, 31 March 1998, page 38, XP000778333 ISSN: 0013-5658
- POUNTAIN D: "EUROPEAN ASIC DESIGNS" BYTE, MCGRAW-HILL INC. ST PETERBOROUGH, US, vol. 23, no. 3, 1 March 1998 (1998-03-01), pages 40IS07-40IS10, XP000773958 ISSN: 0360-5280
- SAWAN M ET AL: "Dynamic configuration using pyramidal architecture FPGA and a built-in RISC processer" MICROELECTRONICS, 1998. ICM '98. PROCEEDINGS OF THE TENTH INTERNATIONAL CONFERENCE ON MONASTIR, TUNISIA 14-16 DEC. 1998, PISCATAWAY, NJ, USA,IEEE, US, 14 December 1998 (1998-12-14), pages 17-20, XP010371962 ISBN: 0-7803-4969-5

## Description

### FIELD OF THE INVENTION

This invention relates to a programmable single chip device; in particular it relates to a programmable single chip device capable of handling high bandwidth signals as may, for example, be associated with third generation cellular telephony, wireless information devices, digital television and wireless LANs such as Bluetooth. A single chip device is a device implemented on a single semiconductor substrate. In addition it relates to a development environment for such a device.

### DESCRIPTION OF THE PRIOR ART

Conventional linear digital signal processors (DSPs) have a small number of high-precision data paths. Whilst this type of processor works well for low-bandwidth signal processing (e.g., audio, low-capacity digital radio), it falls down when looking at higher bandwidth signals such as third-generation cellular, digital television, or wireless local area networks. With such systems, very high linear cycle loadings are imposed by the task groups of modulation and demodulation, channel decoding, and, to some extent, source coding and decoding (e.g., when complex video compression is in use). These groups require the use of inherently parallel or 'wide' algorithms, (e.g., FFT, IFFT, Viterbi, digital decimating downconversion with filtration, despreading etc.,) and these 'wide' algorithms do not map well onto the 'narrow' parallelism offered by conventional linear DSPs. The end result is that very high cycle loadings on the DSP substrate must be imposed if the well-known advantages of software implementation are to be obtained, and indeed, with the latest generation of algorithms, not even the fastest DSPs are fast enough. It is a well-accepted fact within the wireless communications arena, for example, that algorithm complexity is growing faster than Moore's law.

The alternative to a DSP is to use some form of custom gate implementation to implement at least a subset of the 'wide' algorithms, giving the opportunity to execute a large number of data paths in parallel, thereby allowing the actual device to be clocked at a much lower overall rate. However, implementation of floating point datapaths tends to be expensive in terms of gates and HDL (hardware description language) complexity. Synthesis of memory cells is also inefficient. Furthermore, there is an issue with the control logic needed to deal with conditional code (e.g., of the form IF x DO y ELSE DO z). As we traverse the spectrum of algorithms, from fixed point, highly iterative, low conditionality, to floating point, low-iteration, high conditionality, it becomes more efficient to implement a general purpose processing engine, and then feed this with instructions and data, rather than hard coding' the parallel datapaths.

In most communications and broadcast systems, therefore, a conventional DSP is normally retained (together with a custom gate section) to perform the precision arithmetic functions that have more linear dependencies and hence cannot be executed in parallel. To assist in managing resources and high speed i/o, the DSP section will often run some form of real time operating system (RTOS), such as DSP BIOS, VxWorks, OSE, etc.

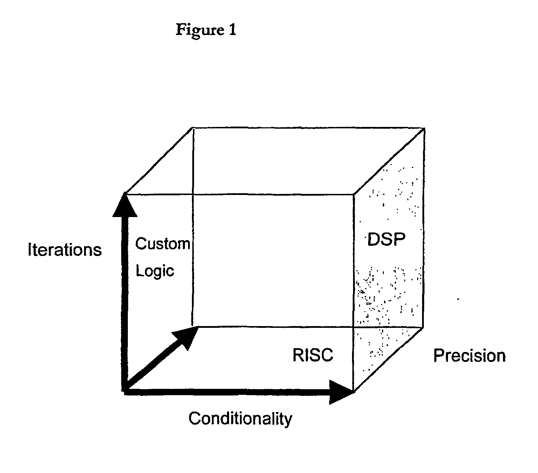

Finally, and at another extreme point of the scale, we have very low cycle tasks (such as human-machine-interface (HMI) control or protocol state machine traversal), which although they may be handled on the DSP, are generally better executed on a separate microcontroller (generally, although not always, these microcontrollers are RISC-based, and so we will refer to this as the RISC core component henceforward). The tasks assigned to the microcontroller tend to contain a lot of conditionality, and have low inherent parallelism (i.e. the tasks may include multiple execution threads which cannot be split up). They generally also have unpredictable load (due to the high conditionality). To assist in executing HMI and peripheral access, the RISC controller will often execute some form of embedded operating system (EmOS) (e.g., Windows CE, EPOC-32, PalmOS, etc.). The taxonomy discussed above is represented in Figure 1.

The end result is that the sorts of demanding application areas mentioned above, such as digital television receivers, wireless LAN moderns, etc., tend to have a system requirement for a custom HDL section, a DSP section, and a RISC microcontroller section. These are generally connected together via some form of shared bus. The other important component is memory, containing code for the DSP, RISC and gate configurations for the FPGA (although the gate configurations are on internal memory), and providing working store for the system (including I/O buffering, to allow processing amortization where the data input or output is bursty).

For very high product volumes (usually, >1,000,000 units), such an architecture will conventionally be mapped into an ASIC (application specific integrated circuit), incorporating the HDL-specified modules as on-chip accelerators, generally accessed via an internal bus, and a DSP core and a RISC core, together with appropriate on-chip memory and I/O modules.

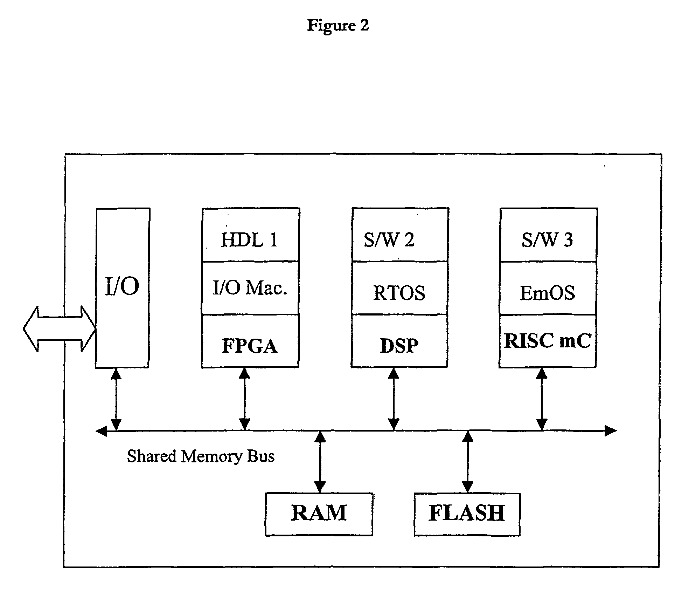

However, for volumes lower than that for which a custom ASIC is cost effective (including the prototyping phase even where an ASIC is the final goal), the only way to implement the 'wide' algorithms within a reasonable timeframe is to use a field-programmable gate array, or FPGA, in conjunction with a discrete DSP component, and a discrete RISC component, connected together via a board-level bus (or buses). However, this leads to a complex overall system design that is not cost-effectively scalable, even to moderate volume, as explained later. A high-level representation of a typical low-volume board for a high-bandwidth application (such as those described earlier) is shown in Figure 2.

For low to medium volume production of high-bandwidth products, then, the current development paradigm, resulting in the sort of system card shown in Figure 2 has a number of disadvantages, as follows:
- The overall cost of the system is high, as it contains (in the worst case) three separate discrete computational elements (FPGA, DSP and RISC), together with external memory.
- As the shared bus is external to each of the computational elements, its overall speed will be constrained, and it will also potentially suffer from significant EMC issues.
- Development cycle time is increased, because passing data between these process elements has to be explicitly managed in each (using whatever vendor-provided communications HDL macros the FPGA has, the communications facilities provided by the RTOS chosen for the DSP, and the communications facilities provided by the EmOS chosen for the RISC, for example).
- Mobility (during the design phase) of algorithms between the various processing elements, and 'simulatability' of the system, is likewise reduced by the fact that various vendor's development environments will have to be used for each, and these environments will not generally interoperate in a straightforward manner.
- The system board is likely to have high power consumption, given the discrete device count.
- The system board is likely to have complex power regulation requirements, since it is unlikely that each of the devices will have a common input voltage.
- The system board will be fairly large and this may limit its usability in certain space-constrained applications.
- The system board is not straightforward to modify once it is in the field - since downloaded algorithms for e.g., the FPGA would require the (usually external) programming tool to allow uploading into the device's internal non-volatile RAM.
- Even if the design is successful, migration to an ASIC is not straightforward, since design tools from a number of different vendors have been used, with a number of different 'virtual machines' utilised to associate the logical interconnects.

It is known to combine RISC and FPGA computational elements into a single programmable device, see for example Gokhale MB et al : "NAPA C: compiling for a hybrid RISC/FPGA architecture" FPGAS For Custom Computing Machines, 1998, Proceedings IEEE Symposium On Napa Valley, CA, USA 15-17 April 1998, Los Alamitos, CA, USA, IEEE Comput. Soc., 15 April 1998, pages 126-135.

### STATEMENT OF THE PRESENT INVENTION

In accordance with the present invention, there is provided a programmable single-chip device, comprising a programmable gate array (PGA) section, a DSP core and a RISC core.

The present invention is ideal for prototyping and deploying low-to-moderate volume implementations of high-bandwidth algorithms, which have processing requirements split between (a) high iteration, low numeric-agility, 'wide' loadings, (b) moderate iteration, high-numerical-precision loadings and (c) low-iteration, highly conditional loadings, without the commensurate problems inherent in the custom ASIC, joint FPGA/DSP/RISC (or even direct compilation to FPGA) solutions.

To date, the possibility of combining a PGA section, DSP core and RISC core onto a programmable single chip device has not been recognised. A prime reason for this is that PGA design, DSP core design and RISC core designs have each been separate technical disciplines, performed by entirely different companies. Further, PGA, DSP and RISC designers typically lack knowledge of the applicable communications applications; yet without this knowledge, the motivation and skills to conceive the present invention is entirely lacking. Another practical barrier to the conception of the present invention is that its practical viability relies on the existence of an effective integrated development environment and run-time virtual machine (see below). Yet to date, these have been unavailable. Hence, as a practical reality therefore, integrating all three computational entities into a single-chip device has therefore not been on any companies' roadmap.

Preferably, the single-chip device further comprises a FLASH store for the gate configuration and DSP and RISC software, RAM for working store and program store when the DSP and RISC devices are running, and fast, DMA-controlled I/O ports (parallel and serial) through which the device can pass data to and from the outside world (e.g., from an ADC or to a DAC).

In one preferred embodiment, the various computational elements are able to pass data between each other using a number of dedicated buses in addition to the common data/address bus.

A common virtual machine (VM) platform may be included for use across the three computational elements, providing a common API for data transfer, concurrency signalling, peripheral and bus contention control etc.

In another aspect, there is provided a development environment for the single-chip device, in which the environment comprises compilers for HDL (for the PGA section), and assemblers for both the DSP and RISC core, and appropriate high-level compilers for the DSP and RISC core also (e.g., C++, C). The development environment may also support the use of 'high level' gate-description development languages (such as Handel-C).

The development environment may contain a set of system-spanning simulation and timing tools to enable straightforward design verification, and may also contain a set of libraries implementing common, useful functions not directly provided at the virtual machine layer. The development environment also contains driver code (and appropriate hardware (e.g., a JTAG card) to enable the compiled *total sytem description* (TSD, consisting of e.g., a JDEC fuse map for the PGA, together with machine code for the DSP and RISC cores and any appropriate lookup tables, etc.) to be uploaded into the single-chip device. Automatic migration to an ASIC can be achieved using the compiled total system description. The development environment may also contain the ability to run a real-time source level debugger. Because of the unique architecture, users are able to set breakpoints anywhere in the system description, regardless of whether the module in question executes over the PGA, DSP or RISC computational substrate. A common virtual machine may be provided for the development of each of the three computational elements, enabling algorithm mobility across these elements.

### BRIEF DESCRIPTION OF THE DRAWINGS

The invention will be described with reference to the accompanying Figures in which:
Figure 1 depicts the Prior Art - Variables Constraining Processing Substrate Choice;
Figure 2 depicts the Prior Art - Typical Low-Volume High-Bandwidth System Card;
Figure 3 depicts a programmable single chip device in accordance with the invention;
Figure 4 depicts schematically a development environment in accordance with the present invention.

### DETAILED DESCRIPTION

The invention will be described with reference to an implementation from RadioScape Limited of the United Kingdom.
RadioScape's system, which for convenience we term the *Optimal Parallel Processing Substrate* (OPPS), comprises three main elements:
1. A generic, programmable single-chip device, containing a programmable gate array (PGA) section, a DSP core and a RISC core, together with FLASH store for the gate configuration and DSP and RISC software, RAM for working store and program store when the DSP and RISC devices are running, and fast, DMA-controlled I/O ports (parallel and serial) through which the device can pass data to and from the outside world (e.g., from an ADC or to a DAC). In one preferred embodiment, the various computational elements are able to pass data between each other using a number of dedicated busses in addition to the common data/address bus.
2. A common virtual machine (VM) platform provided for use across the three computational elements, providing a common API for data transfer, concurrency signalling, peripheral and bus contention control etc. This common VM layer also allows (at the interface level) modules to have their I/O and concurrency requirements expressed without reference to which computational element is actually to be used as their substrate. In one preferred embodiment, the VM layer is the communications virtual machine layer described in PCT/GB01/00273. A 'virtual machine' typically defines the functionality and interfaces of the ideal machine for implementing a particular application set relevant to the present invention. It typically presents to the using application an ideal machine, optimised for the task in hand, and hides the irregularities and deficiencies of the actual hardware. The 'virtual machine' may also manage and/or maintain one or more state machines modelling or representing communications processes. The 'virtual machine layer' is the software that makes a real machine look like this ideal one. This layer will typically be implemented differently for every real machine type, but provide a common interface to higher level software across all platforms. A 'virtual machine layer' typically refers to a layer of software which provides a set of one or more APIs (Application Program Interfaces) to perform some task or set of tasks and which also owns the critical resources that must be allocated and shared between the elements using the VM layer. It should be noted that this common spanning VM layer does not preclude the use of a specific RTOS / EmOS in addition, it simply provides a common data and control plane through which modules of the application may intercommunicate seamlessly regardless of the computational element utilised.
3. A single development environment for the device, containing compilers for HDL (for the PGA section), and assemblers for both the DSP and RISC core, and appropriate high-level compilers for the DSP and RISC core also (eg., C++, C). The development environment may also (optionally) support the use of 'high level' gate-description development languages (such as Handel-C). The development environment contains a set of mathematical modelling system-spanning simulation and timing tools to enable straightforward design verification, and may also contain a set of libraries implementing common, useful functions not directly provided at the virtual machine layer. The development environment also contains driver code (and appropriate hardware (e.g., a JTAG card) to enable the compiled *total system description* (TSD, consisting of e.g., a JDEC fuse map for the PGA, together with machine code for the DSP and RISC cores and any appropriate lookup tables, etc.) to be uploaded into the device described in (1) above. The development environment also contains the ability to run a real-time source level debugger, again using appropriate connection hardware to the device, and because of the unique architecture users are able to set breakpoints anywhere in the system description, regardless of whether the module in question executes over the PGA, DSP or RISC computational substrate.

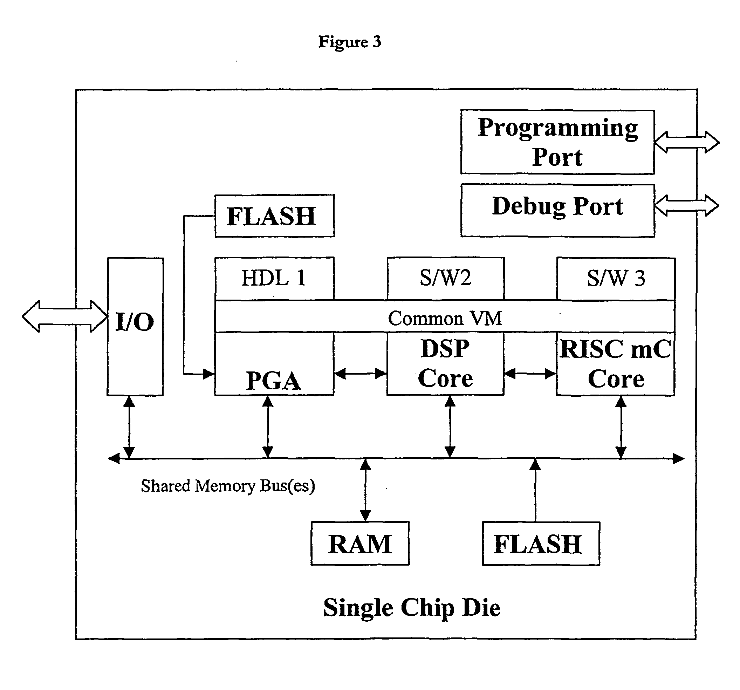

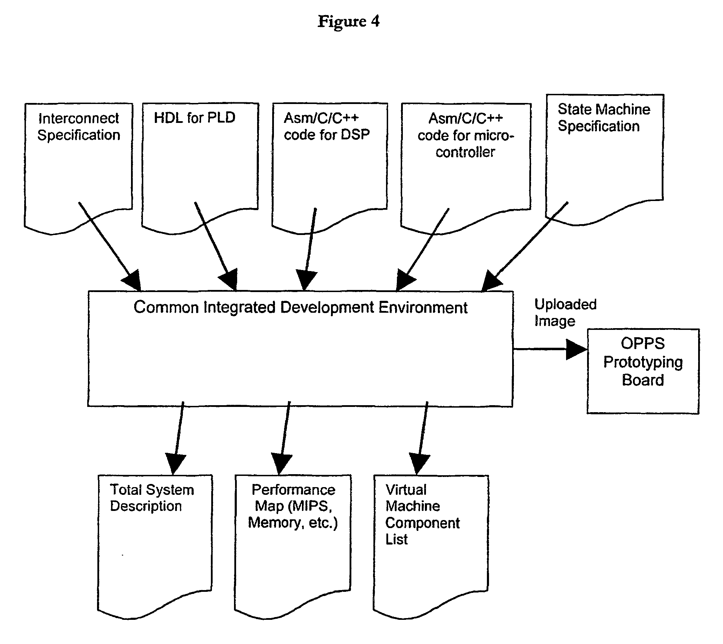

A diagrammatic representation of an implementation of the single chip device is given in Figure 3. The development environment is shown schematically in Figure 4.

The Radioscape OPPS implementation provides significant advantages for low-to-moderate volume implementation of high-bandwidth applications, compared to the system board approach, as described below:
- The overall cost of the system is low, as in the general case it will operate as a single chip, with few external components needed. Furthermore, because of the large number of high-bandwidth applications where low-to-medium volume numbers of devices are required (e.g., emerging markets for new digital standards), the chip vendor will be able to sustain a very high overall volume of production for the device, further lowering costs.
- The use of an internal main shared bus for intercommunication between the computational elements, together with the optional use of additional dedicated busses, greatly increases the potential data interchange rate, whilst lowering EMC.
- Development cycle time is greatly reduced, because the three computational elements now share a common 'virtual machine' - therefore passing data between them is effected through identical primitives from the user's point of view.
- Mobility of algorithms between the various processing elements, and 'simulatability' of the system, is likewise greatly enhanced by the fact a single development environment, and a common module API, is in use.
- The device will have much lower power consumption since all its cores are running at a (low) internal voltage, and no capacitive load is imposed by a shared external memory bus.
- Power regulation requirements are simplified since the chip can have a single input voltage.
- The single device will be quite small and capable of being provided in various compact package types (e.g., micro-BGA), facilitating its use in designs where space is at a premium (e.g., mobile phones).
- Because the device (including its non-volatile configuration store for each of the computational elements) is provided in a single chip package (or with additional ROM for the program), it can easily be resold (appropriately programmed) as a custom part for various applications by third-party developers. For example, a company could develop a DVB (digital television) decoder for the device, and then offer pre-programmed devices (together with a datasheet) for sale as catalogue parts in the normal way.
- The device does provide for straightforward modification, even after deployment into the field, since all non-volatile elements are accessible internally. Therefore, it would (for example) be possible to download a new, improved equaliser module 'over the air' into a cellular phone, even where that module executes on the PGA computational element of the device.
- The use of a single virtual machine and development environment makes it possible, should a particular design prove popular, straightforwardly to migrate to an ASIC implementation. Indeed, a vendor of the OPPS chip could make a great virtue of this, offering a fast turnaround custom service that would take the full system description generated from the design tool (which, by definition, entails all the complex timing relationships between the various computational elements), and using this to drive the (ideally automated) production of an appropriate ASIC. In one implementation, the ASIC is provided in an automated manner from the TSD. The vendor would have a strong unique benefit to offer the customer (in terms of fast, painless ASIC migration). Furthermore, since the process of translation to ASIC could be largely or wholly automated (provided that compatible cores for the DSP and RISC were available to the vendor, and assuming that the HDL would be compiled into fixed silicon, and elements of the original OPPS platform unused by the target application would be removed), a further advantage would accrue, namely reliability: the resulting ASIC would operate correctly in the first iteration, compared with the normal process of going through various 'spins' to iron out bugs introduced in the move from system board to ASIC.

So it is clear that this approach is very attractive for low to medium volumes, and indeed greatly facilitates the transfer of the system design to an ASIC when volumes permit. However, it is worth mentioning that the OPPS platform has a number of advantages to offer over the fixed ASIC approach, even in high volumes:
- The flexibility afforded by the ability to re-program deployed devices (e.g., downloading a new equaliser 'over the air' in a communications system), even where the logical component in question is implemented within the custom gate computational substrate, represents a significant benefit for many applications, only possible with a re-programmable device.
- The ability to rapidly generate new code to 'tune' an application-programmed device for a particular OEM deployment (e.g., by changing only the HMI code for the RISC device) represents a significant potential benefit.

In short, the OPPS represents a hardware platform optimised for modern high-bandwidth broadcast and communication tasks, in which the need for high parallelism, high precision numerical computation and HMI interaction is satisfied by a single hardware substrate. This allows the OPPS vendor to optimise volume of manufacture, driving costs down, while allowing application developers to write software-only applications under a common development environment, to a common VM, with all the productivity benefits that entails, knowing that they can sell their IP not merely as a 'system board' but as a catalogue-part chip (without the expense of spinning an ASIC), furthermore secure in the knowledge that they have a straightforward, rapid, reliable (and ideally automated) route to an ASIC should volumes subsequently permit.

Other types of non-volatile store could be used anywhere 'FLASH' memory is mentioned.

The ability to 'read protect' the uploaded system description can be provided - so that shipped 'application customised' chips are not susceptible to piracy.

The device may use external FLASH, fixed ROM or other store for its DSP and RISC program store if desired. An external memory access bus may also be supported if desired.

## Claims

1. A programmable single-chip device, comprising at least the following computational elements: a programmable gate array section, a digital signal processor DSP core and a reduced instruction set computer RISC core.

2. The single-chip device of Claim 1 further comprising a FLASH store for the gate configuration and DSP and RISC software, RAM for working store and program store when the DSP and RISC devices are running, and a DMA-controlled I/O ports.

3. The single chip device of any preceding Claim in which the computational elements are able to pass data between one another using a number of dedicated buses in addition to a common data/address bus.

4. The single chip device of any preceding claim in which there is provided a common virtual machine platform for use across each of the three computational elements.

5. The single-chip device of Claim 4 in which the common virtual machine platform provides a common API for one or more of the following: data transfer, concurrency signalling, peripheral and bus contention control.

6. A development environment for the single-chip device as defined in Claims 1 - 5, in which the environment comprises: (a) a compiler for HDL for the programmable gate array section; (b) assemblers for both the DSP and RISC core; and (c) high-level compilers for the DSP and RISC core.

7. The development environment of Claim 6 in which a common virtual machine is provided for all of the three computational elements.

8. The development environment of Claim 7 in which algorithm mobility across one or more of the computational elements is achievable using the common virtual machine.

9. The development environment of Claim 6 - 8 further comprising a set of simulation and timing tools to enable design verification.

10. The development environment of Claims 6 - 9 further comprising driver code to enable the compiled total system description to be uploaded into the single-chip device.

11. The development environment of Claims 6 - 10 in which the single-chip device can be any chip device used in a high-bandwidth application for which low to medium numbers of devices are required.

12. The development environment of Claim 11 in which the single-chip device belongs to one of the following set of device types: digital TV receivers, wireless LAN modems, third generation cellular mobile telephones, wireless information devices.

13. The development environment of Claims 6 - 12 in which automatic migration to an ASIC is achievable using a compiled total system description.

## Patentansprüche

1. Programmierbares Ein-Chip-Bauelement, umfassend wenigstens die folgenden Rechenelemente: einen programmierbaren Gate-Array-Teil, einen Digitalsignalprocessor-(DSP)-Kern und einen RISC-(Computer mit eingeschränktem Befehlsvorrat)-Kern.

2. Ein-Chip-Bauelement nach Anspruch 1, ferner umfassend einen FLASH-Speicher für die Gatterkonfiguration und DSP- und RISC-Software, RAM für Arbeitsspeicher und Programmspeicher, wenn die DSP- und RISC-Bauelemente laufen, und DMA-gesteuerte E/A-Ports.

3. Ein-Chip-Bauelement nach einem der vorherigen Ansprüche, bei dem die Rechenelemente unter Verwendung einer Reihe von dedizierten Bussen zusätzlich zu einem gemeinsamen Daten-/Adressbus Daten untereinander übertragen können.

4. Ein-Chip-Bauelement nach einem der vorherigen Ansprüche, bei dem eine gemeinsame virtuelle Maschinenplattform für die Verwendung über jedes der drei Rechenelemente bereitgestellt wird.

5. Ein-Chip-Bauelement nach Anspruch 4, bei dem die gemeinsame virtuelle Maschinenplattform eine gemeinsame API für eine oder mehrere der folgenden Abläufe bereitstellt: Datenübertragung, Simultanitätssignalisierung, Peripheriegerätund Buskonkurrenzsteuerung.

6. Entwicklungsumgebung für das Ein-Chip-Bauelement gemäß Definition in den Ansprüchen 1 - 5, wobei die Umgebung Folgendes umfasst: (a) einen Compiler für HDL für den programmierbaren Gate-Array-Teil; (b) Assembler für den DSP- und den RISC-Kern, und (c) High-Level-Compiler für den DSP- und den RISC-Kern.

7. Entwicklungsumgebung nach Anspruch 6, wobei eine gemeinsame virtuelle Maschine für alle drei Rechenelemente vorgesehen ist.

8. Entwicklungsumgebung nach Anspruch 7, wobei Algorithmusmobilität über ein oder mehrere der Rechenelemente mit der gemeinsamen virtuellen Maschine erzielbar ist.

9. Entwicklungsumgebung nach den Ansprüchen 6 - 8, ferner umfassend einen Satz von Simulations- und Timing-Tools, um Designverifizierung zu ermöglichen.

10. Entwicklungsumgebung nach den Ansprüchen 6 - 9, ferner umfassend Treibercode, um es zu ermöglichen, dass die kompilierte Gesamtsystembeschreibung in das Ein-Chip-Bauelement heraufgeladen wird.

11. Entwicklungsumgebung nach den Ansprüchen 6 - 10, wobei das Ein-Chip-Bauelement ein beliebiges Chip-Bauelement sein kann, das in einer Breitbandanwendung eingesetzt werden kann, für die kleine bis mittelgroße Anzahlen von Bauelementen benötigt werden.

12. Entwicklungsumgebung nach Anspruch 11, wobei das Ein-Chip-Bauelement zu einem aus dem folgenden Satz von Bauelementetypen gehört: Digital-TV Empfänger, drahtlose LAN-Modeme, mobile Zellulartelefone der dritten Generation, drahtlose Informationsgeräte.

13. Entwicklungsumgebung nach den Ansprüchen 6 - 12, wobei eine automatische Umstellung auf eine ASIC unter Verwendung einer kompilierten Gesamtsystembeschreibung erzielbar ist.

## Revendications

1. Dispositif monopuce programmable, comportant au moins les éléments de calcul suivants : une section de type matrice prédiffusée programmable, un coeur de processeur de signal numérique (DSP) et un coeur d'ordinateur à jeu d'instructions réduit (RISC)

2. Dispositif monopuce selon la revendication 1, comportant par ailleurs une mémoire FLASH pour la configuration des portes et les logiciels de DSP et de RISC, une mémoire RAM pour la mémoire de travail et la mémoire de programmes lorsque les dispositifs de DSP et de RISC fonctionnent, et des pôles d'entrée-sortie commandés par DMA.

3. Dispositif monopuce selon l'une quelconque des revendications précédentes, dans lequel les éléments de calcul sont en mesure de faire passer des données entre eux par le biais d'un certain nombre de bus spécialisés en plus d'un bus commun de données/d'adresses.

4. Dispositif monopuce selon l'une quelconque des revendications précédentes, dans lequel il est prévu une plate-forme de machine virtuelle commune destinée à être utilisée sur chacun des trois éléments de calcul.

5. Dispositif monopuce selon la revendication 4, dans lequel la plate-forme de machine virtuelle commune procure une interface de programmation commune pour un ou plusieurs des processus suivants : transfert de données, signalisation d'accès simultané, contrôle des conflits d'accès aux périphériques et aux bus.

6. Environnement de développement pour le dispositif monopuce tel que défini selon les revendications 1 à 5, dans lequel l'environnement comporte : (a) un compilateur pour HDL pour la section de type matrice prédiffusée programmable ; (b) des assembleurs pour le coeur de DSP et le coeur de RISC ; et (c) des compilateurs de haut niveau pour le coeur de DSP et le coeur de RISC.

7. Environnement de développement selon la revendication 6, dans lequel une machine virtuelle commune est prévue pour l'ensemble des trois éléments de calcul.

8. Environnement de développement selon la revendication 7, dans lequel la mobilité d'algorithme sur l'un ou plusieurs des éléments de calcul est réalisable par le biais de la machine virtuelle commune.

9. Environnement de développement selon les revendications 6 à 8, comportant par ailleurs un jeu d'outils de simulation et de synchronisation pour permettre la vérification de la conception.

10. Environnement de développement selon les revendications 6 à 9, comportant par ailleurs un code pilote pour permettre à la description compilée du système dans sa totalité d'être téléchargée dans le dispositif monopuce.

11. Environnement de développement selon les revendications 6 à 10, dans lequel le dispositif monopuce peut être n'importe quel dispositif monopuce utilisé dans une application à large bande passante pour laquelle un nombre de faible à moyen de dispositifs sont nécessaires.

12. Environnement de développement selon la revendication 11, dans lequel le dispositif monopuce appartient à l'un de l'ensemble suivant de types de dispositifs : téléviseurs numériques, modems sans fil de réseau local, téléphones mobiles de troisième génération, terminaux d'informations sans fil.

13. Environnement de développement selon les revendications 6 à 12, dans lequel la migration automatique vers un ASIC est réalisable par le biais d'une description compilée du système dans sa totalité.
